# EUROPEAN PATENT APPLICATION

(11) **EP 0 853 344 A1**
(43) Date of publication of application: **15.07.1998**
(21) Application number: 97310539.8
(22) Date of filing: 23.12.1997
(51) Int. Cl.: H01L 29/739

(54) **Semiconductor device employing tunnel effect and method of fabricating the same**

(30) Priority: 27.12.1996 JP 350537/96
(71) Applicant: SANYO ELECTRIC CO. LTD, Moriguchi-shi, Osaka-fu 570 (JP)
(72) Inventor: Matsumura, Kohji, Hirakata-shi, Osaka-fu 573 (JP); Matsushita, Shigeharu, Katano-shi, Osaka-fu 576 (JP); Inoue, Daijiro, Kyoto-shi, Kyoto-fu 615 (JP); Harada, Yasoo, Hirakata-shi, Osaka-fu 573-01 (JP)
(74) Representative: Calderbank, Thomas Roger

(57) **Abstract**

A buffer layer (2), a barrier layer (3), a channel layer (4) and another barrier layer (5) are successively formed on a semiinsulating semiconductor substrate (1). The forbidden bandwidths of the barrier layers (3,5) holding the channel layer (4) therebetween are larger than that of the channel layer (4). The channel layer (4) is of a p⁺-type doped in high concentration, and a gate electrode opposed part (6) in the channel layer is of an n⁺-type doped in high concentration. The gate electrode opposed part (6) in the channel layer is formed by Si diffusion/doping from an SiOₓ/SiN multilayer film.

## Description

The present invention relates to a semiconductor device employing the tunnel effect, which can be implemented with a higher degree of integration and is operable at a high speed, and a method of fabricating the same.

Following implementation of an LSI (large-scale integrated circuit) with a higher degree of integration, transistors employed therein are refined year by year. If the gate lengths of MOS (metal-oxide semiconductor) transistors are reduced to not more than 0.1 µm, however, various problems such as fluctuation of threshold voltages are caused by dispersion between the channel lengths of the devices or the quantum effect.

In order to solve such problems, a surface tunnel transistor (hereinafter referred to as an STT) has been proposed (refer to Japanese Patent Laying-Open Gazette No. 5-175494 (1993), for example).

In this STT, a p⁺-type semiconductor and an n⁺-type semiconductor which are doped with impurities for deciding the conductivity types thereof in high concentrations respectively to be degenerated are abruptly joined with each other (abrupt junction). Thus, the potential energy of the valence band of the p⁺-type semiconductor and that of the conduction band of the n⁺-type semiconductor approach to each other while the thickness of a depletion layer formed at the P-N junction interface between the p⁺-type and n⁺-type semiconductors is reduced, thereby developing the so-called tunnel current at the P-N junction by electrons.

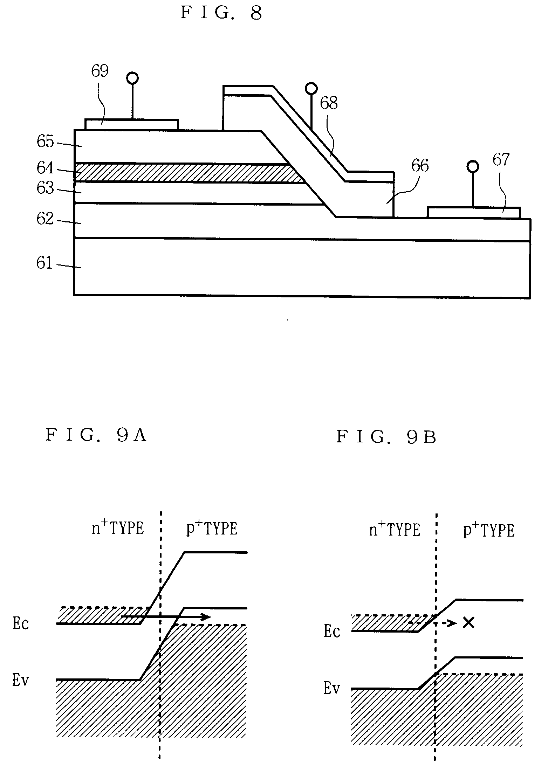

Fig. 8 is a typical sectional view showing the device structure of the aforementioned STT, and Figs. 9A and 9B are energy band diagrams showing the potential profiles of a tunnel junction part in the STT shown in Fig. 8 (refer to Japanese Patent Laying-Open Gazette No. 6-260657 (1994), for example).

Referring to Fig. 8, an n⁺-type GaAs layer 62 for serving as a source, an undoped GaAs layer 63, an n⁺-type GaAs layer 64 and a p⁺-type GaAs layer 65 for serving as a drain are formed on a semi-insulating GaAs substrate 61. The n⁺-type GaAs layer 64 and the p⁺-type GaAs layer 65 form a functional tunnel junction of this device.

The n⁺-type GaAs layer 62, the undoped GaAs layer 63, the n⁺-type GaAs layer 64 and the p⁺-type GaAs layer 65 are etched to define a mesa shape. An n-type AlGaAs layer 66 is formed on an exposed side surface of the mesa shape. A Schottky gate electrode 68 for controlling a tunnel current is formed on the n-type AlGaAs layer 66. Ohmic source and drain electrodes 67 and 69 for extracting carriers are formed on the n⁺-type and p⁺-type GaAs layers 62 and 65 respectively.

Epitaxy such as MBE (molecular beam epitaxy) or MOCVD (metal-organic chemical vapor deposition) is employed for forming the respective semiconductor layers of this STT to obtain abrupt junction interfaces therebetween, thereby obtaining the structure shown in Fig. 8 formed by stacking parallel semiconductor layers on the surface of the substrate 61. In order to form the source electrode 67 on the n⁺-type GaAs layer 62 for serving as a source, it is necessary to partially remove all layers provided on the n⁺-type GaAs layer 62, i.e., the undoped GaAs layer 63, the n⁺-type GaAs layer 64 and the p⁺-type GaAs layer 65, by etching. In order to form the gate electrode 68 on the exposed side surface of the mesa shape, further, it is necessary to selectively form the n-type AlGaAs layer 66 on the side surface of the mesa shape after the etching.

The device structure of this STT is characterized in that an abrupt P-N junction formed by degenerated p⁺- and n⁺-type semiconductors (the p⁺- and n⁺-type GaAs layers 65 and 64) is employed, and the gate electrode 68 is provided on the P-N junction for controlling the tunneling probability.

Due to this structure, the potential energy of the valence band of the p⁺-type semiconductor approaches to that of the conduction band of the n⁺-type semiconductor and the thickness of the depletion layer on the P-N junction interface is reduced, whereby the tunneling probability of electrons at the P-N junction interface can be increased.

The operation principle of the STT shown in Fig. 8 is now described with reference to Figs. 9A and 9B. Referring to each of Figs. 9A and 9B, portions above symbol Ec are conduction bands, those under symbol Ev are valence bands, and the portions therebetween are forbidden bands. Slant lines show portions where electrons are present.

When a positive voltage is applied between the source electrode and the drain electrode, for example, the STT has the band structure shown in Fig. 9A. In this case, the electrons injected from the source electrode pass through the forbidden band of the P-N junction part from the conduction band of the n⁺-type semiconductor due to the tunnel effect, and further passes through the valence band of the p⁺-type semiconductor to reach the drain electrode. Thus, a drain current flows between the source electrode and the drain electrode.

When a voltage is applied to the gate electrode in this state, the carrier concentration of the n⁺-type semiconductor is changed, thereby changing the tunneling probability of the electrons in the P-N junction part. Consequently, the drain current is changed. Fig. 9B shows such a state that the electrons hardly flow due to the application of a positive voltage to the gate electrode. Namely, the STT operates as a three-terminal element controlling the drain current by the gate electrode.

As hereinabove described, the STT is characterized in that the same is hardly influenced by dispersion of the gate lengths due to the employment of only the abruptness of the P-N junction part, and the quantum effect of the tunnel effect is employed as the operation principle. Consequently, the STT is operable even if the element is refined to not more than 0.1 µm.

However, the conventional STT requires the etching for forming the source electrode and the selective semiconductor formation (selective growth) for forming the gate electrode in fabrication, as hereinabove described.

These complicated processes result in increase of the element fabrication cost and reduction of the yield. In particular, it is difficult to further refine the element due to the necessity for the selective growth for providing the gate electrode on the side surface of the mesa shape.

An object of the present invention is to attain improvement of the yield, reduction of the cost, further refinement and higher integration of a semiconductor device employing the tunnel effect.

Another object of the present invention is to provide a method of fabricating a semiconductor device employing the tunnel effect which enables improvement of the yield, reduction of the cost, further refinement and higher integration.

A semiconductor device according to an aspect of the present invention comprises a first semiconductor layer, a second semiconductor layer, a third semiconductor layer and a gate electrode in this order. The second semiconductor layer has a narrower forbidden bandwidth than the third semiconductor layer, and a first region opposed to the gate electrode in the second semiconductor layer has a first conductivity type, while a second region adjacent to at least one side of the first region in the second semiconductor layer has a second conductivity type which is reverse to the first conductivity type.

In this semiconductor device, the first and second regions in the second semiconductor layer form a P-N junction interface. Carriers injected into the second semiconductor layer through the third semiconductor layer pass through the forbidden band of the P-N junction part formed in the second semiconductor layer by the tunnel effect. Thus, a current flows in the second semiconductor layer. When a voltage is applied to the gate electrode in this state, the carrier concentration in the first region of the second semiconductor layer is changed, thereby changing the tunneling probability of the carriers in the P-N junction part of the second semiconductor layer. Consequently, the current flowing in the second semiconductor layer is changed.

This semiconductor device has a planar structure, whereby the yield in fabrication is improved and reduction of the cost is enabled. In addition, further refinement and higher integration are attained.

The second region may include regions located on both sides of the first region in the second semiconductor layer. In this case, fabrication is simplified.

The first semiconductor layer may have a larger forbidden bandwidth than the second semiconductor layer. In this case, the forbidden bandwidths of the first and third semiconductor layers holding the second semiconductor layer therebetween are larger than that of the second semiconductor layer, whereby the potential energy of the second semiconductor layer is lower than those of the first and third semiconductor layers. Thus, the carriers injected into the second semiconductor layer through the third semiconductor layer are confined in the second semiconductor layer, to transit therein.

The first semiconductor layer may have a forbidden bandwidth substantially equal to that of the second semiconductor layer. In this case, crystal growth conditions of the first and second semiconductor layers are substantially identical to each other, whereby the second semiconductor layer can be readily formed on the first semiconductor layer.

It is preferable that the first region is doped with first conductivity type impurities in high concentration, the second region is doped with second conductivity type impurities in high concentration, and the first and second regions form an abrupt P-N junction interface. Thus, the potential energy of the valence band of one of the first and second regions in the second semiconductor layer approaches to that of the conduction band of the other region, and the thickness of a depletion layer at the P-N junction interface is reduced. Consequently, the tunneling probability of the carriers at the P-N junction interface can be increased.

The semiconductor device may further comprise a semiconductor substrate and a buffer layer formed on the semiconductor substrate, so that the first semiconductor layer is formed on the buffer layer.

The semiconductor device may further comprise a semiconductor substrate, so that the first semiconductor layer is formed on the semiconductor substrate.

The semiconductor device may further comprise first and second ohmic electrodes formed on both sides of the gate electrode on the third semiconductor layer respectively. Thus, the carriers can be injected into the second semiconductor layer through the third semiconductor layer by the first and second ohmic electrodes.

The first semiconductor layer may be formed of AlGaAs or GaAs, the second semiconductor layer may be formed of InGaAs, and the third semiconductor layer may be formed of AlGaAs. Alternatively, the first semiconductor layer may be formed of InAlAs, the second semiconductor layer may be formed of InGaAs or InAs, and the third semiconductor layer may be formed of InAlAs.

The first region of the second semiconductor layer may be formed by diffusing the first conductivity type impurities into a second conductivity type semiconductor.

The first region may be formed of an n-type semiconductor material, and the second region may be formed of a p-type semiconductor material.

The semiconductor device may further comprise source and drain electrodes formed on the third semiconductor layer on both sides of the gate electrode respectively, so that the second region is a region adjacent to the first region on the drain electrode side in the second semiconductor layer, the first region and a region adjacent to the first region on the source electrode side are formed of an n-type semiconductor, and the second region is formed of a p-type semiconductor.

The semiconductor device may further comprise source and drain electrodes formed on the third semiconductor layer on both sides of the gate electrode respectively, so that the second region is a region adjacent to the first region on the source electrode side in the second semiconductor layer, the first region and a region adjacent to the first region on the drain electrode side are formed of a p-type semiconductor and the second region is formed of an n-type semiconductor.

The third semiconductor layer may be a compound semiconductor formed of AlGaAs having an Al mole ratio of at least 0.25. The first semiconductor layer may be a compound semiconductor formed of AlGaAs having an Al mole ratio of at least 0.25.

A method of fabricating a semiconductor device according to another aspect of the present invention comprises steps of forming a first semiconductor layer, a second semiconductor layer and a third semiconductor layer having a larger forbidden bandwidth than the second semiconductor layer in this order so that the interfaces thereof are parallel to each other, forming a first region opposed to a gate electrode forming region on the third semiconductor layer in the second semiconductor layer and a second region adjacent to at least one side of said first region in the second semiconductor layer in conductivity types reverse to each other, and forming a gate electrode on the gate electrode forming region on the third semiconductor layer.

In the semiconductor device fabricated by this method, the first and second regions in the second semiconductor layer form a P-N junction interface. Carriers injected into the second semiconductor layer through the third semiconductor layer pass through the forbidden band of the P-N junction part formed in the second semiconductor layer by the tunnel effect. Thus, a current flows in the second semiconductor layer. When a voltage is applied to the gate electrode in this state, the carrier concentration in the first region of the second semiconductor layer is changed, thereby changing the tunneling probability of the carriers in the P-N junction part of the second semiconductor layer. Consequently, the current flowing in the second semiconductor layer is changed.

This method implements a semiconductor device of a planar structure employing the tunnel effect, whereby the yield in fabrication is improved and reduction of the cost is enabled. In addition, further refinement and higher integration of the semiconductor device are attained.

The second region may include regions located on both sides of the first region in the second semiconductor layer. In this case, fabrication is simplified.

The first semiconductor layer may have a larger forbidden bandwidth than the second semiconductor layer. In this case, the forbidden bandwidths of the first and third semiconductor layers holding the second semiconductor layer therebetween are larger than that of the second semiconductor layer, whereby the potential energy of the second semiconductor layer is lower than those of the first and third semiconductor layers. Thus, the carriers injected into the second semiconductor layer through the third semiconductor layer are confined in the second semiconductor layer, to transit therein.

The first semiconductor layer may have a forbidden bandwidth substantially equal to that of the second semiconductor layer. In this case, crystal growth conditions of the first and second semiconductor layers are substantially identical to each other, whereby the second semiconductor layer can be readily formed on the first semiconductor layer.

The step of forming the first and second regions in the conductivity types reverse to each other may include a step of doping the first region with first conductivity type impurities in high concentration and doping the second region with second conductivity type impurities in high concentration thereby forming an abrupt P-N junction interface between the first and second regions.

Thus, the potential energy of the valence band of one of the first and second regions in the second semiconductor layer approaches to that of the conduction band of the other region, and the thickness of a depletion layer on the P-N junction interface is reduced. Consequently, the tunneling probability of the carriers on the P-N junction interface can be increased.

The step of forming the first and second regions in the conductivity types reverse to each other may include a step of diffusing the first conductivity type impurities in a second conductivity type semiconductor.

The step of forming the first and second regions in the conductivity types reverse to each other may include steps of forming a film containing an element for serving as the first conductivity type impurities in excess on a gate electrode forming region on the third semiconductor layer, and diffusing the element for serving as the first conductivity type impurities contained in the film into the second semiconductor layer through the third semiconductor layer by heat treatment.

In this case, the element contained in the film in excess is readily decomposed by the heat treatment, to be diffused into the second semiconductor layer through the third semiconductor layer. Thus, a P-N junction interface is formed in the second semiconductor layer.

The step of forming the first and second regions in the conductivity types reverse to each other may include steps of forming a multilayer film of an SiOₓ film (x < 2) and an SiN film on the gate electrode forming region on the third semiconductor layer, and diffusing Si contained in the multilayer film into the second semiconductor layer through the third semiconductor layer by heat treatment.

In this case, the SiOₓ film (x < 2) has Si-excessive film quality as compared with a stable SiO₂ film, whereby excess Si is readily decomposed by the heat treatment to be diffused into the second semiconductor layer through the third semiconductor layer. Thus, the Si concentration is reduced by at least one figure within a five-molecule layer at the interface between the Si-diffused part and the non-diffused part, whereby an extremely abrupt P-N junction interface is formed in the second semiconductor layer.

Si diffused in the third semiconductor layer may be inactive. Thus, the third semiconductor layer remains undoped.

The third semiconductor layer may be a compound semiconductor formed of AlGaAs having an Al mole ratio of at least 0.25. In this case, Si diffused in the third semiconductor layer is not activated as a dopant supplying carriers, whereby the third semiconductor layer remains undoped.

The first semiconductor layer may be a compound semiconductor formed of AlGaAs having an Al mole ratio of at least 0.25. In this case, Si diffused in the first semiconductor layer is not activated as a dopant supplying carriers, whereby the first semiconductor layer remains undoped.

The method of fabricating a semiconductor device may further comprise a step of forming first and second ohmic electrodes on both sides of the gate electrode forming region on the third semiconductor layer respectively.

Thus, the carriers can be injected into the second semiconductor layer through the third semiconductor layer by the first and second ohmic electrodes.

The step of forming the first and second regions in the conductivity types reverse to each other may include steps of forming a film containing an element serving as the first conductivity type impurities in excess on the gate electrode forming region on the third semiconductor layer and on a region adjacent to the gate electrode forming region on a source region forming region side and diffusing the element serving as the first conductivity type impurities contained in the film into the second semiconductor layer through the third semiconductor layer by heat treatment.

The step of forming the first and second regions in the conductivity types reverse to each other may include steps of forming a film containing an element for serving as the second conductivity type impurities in excess on a region adjacent to the gate electrode forming region on the source electrode forming region side of the third semiconductor layer and diffusing the element for serving as the second conductivity type impurities contained in the film into the second semiconductor layer through the third semiconductor layer by heat treatment.

The step of forming the first and second regions in the conductivity types reverse to each other may include steps of forming a multilayer film of an SiOₓ film (x < 2) and an SiN film on the gate electrode forming region of the third semiconductor layer and on the region adjacent to the gate electrode forming region on the source electrode forming region side and diffusing Si contained in the multilayer film into the second semiconductor layer through the third semiconductor layer by heat treatment.

The step of forming the first and second regions in the conductivity types reverse to each other may include steps of forming a multilayer film of an SiOₓ film (x < 2) and an SiN film on the region adjacent to the gate electrode forming region on the source electrode forming region side of the third semiconductor layer and diffusing Si contained in the multilayer film into the second semiconductor layer through the third semiconductor layer by heat treatment.

A method of fabricating a semiconductor device according to still another aspect of the present invention comprises steps of forming a first semiconductor layer, a second semiconductor layer and a third semiconductor layer in this order so that the interfaces thereof are parallel to each other, forming a multilayer film of an SiOₓ film (x < 2) and an SiN film on a prescribed region with reference to a gate electrode forming region on the third semiconductor layer, diffusing Si contained in the multilayer film into the second semiconductor layer through the third semiconductor layer by heat treatment, and forming a gate electrode on the gate electrode forming region on the third semiconductor layer.

According to this fabrication method, the SiOₓ film (x < 2) has Si-excessive film quality as compared with a stable SiO₂ film, whereby excess Si is readily decomposed by the heat treatment to be diffused into the second semiconductor layer through the third semiconductor layer. In this case, the Si concentration is reduced by at least one figure within a five-molecule layer at the interface between the Si diffused part and the non-diffused part, whereby an extremely abrupt P-N junction interface is formed in the second semiconductor layer.

Si diffused in the third semiconductor layer may be inactive. In this case, the third semiconductor layer remains undoped.

The third semiconductor layer may be a compound semiconductor formed of AlGaAs having an Al mole ratio of at least 0.25. In this case, Si diffused in the third semiconductor layer is not activated as a dopant supplying carriers, whereby the third semiconductor layer remains undoped.

The first semiconductor layer may be a compound semiconductor formed of AlGaAs having an Al mole ratio of at least 0.25. In this case, Si diffused in the first semiconductor layer is not activated as a dopant supplying carriers, whereby the first semiconductor layer remains undoped.

The prescribed region with reference to the gate electrode forming region may be the gate electrode forming region. The prescribed region with reference to the gate electrode forming region may be the gate electrode forming region and a region adjacent to the gate electrode forming region on a source electrode forming region side. The prescribed region with reference to the gate electrode forming region may be the region adjacent to the gate electrode forming region on the source electrode forming region side.

The foregoing and other objects, features, aspects and advantages of the present invention will become more apparent from the following detailed description of the present invention when taken in conjunction with the accompanying drawings.
Fig. 1 is a typical sectional view showing the structure of a semiconductor device according to a first embodiment of the present invention;
Figs. 2A, 2B, 2C and 2D are typical sectional views showing steps of a method of fabricating the semiconductor device shown in Fig. 1;
Fig. 3 illustrates the relation between presence/absence of a doped layer formed by an SiOₓ film and the film quality of the SiOₓ film;
Fig. 4 is a typical sectional view showing the structure of a semiconductor device according to a second embodiment of the present invention;
Fig. 5 illustrates the relation between the Al mole ratio of AlGaAs and the electron concentration in AlGaAs;
Fig. 6 is a typical sectional view showing the structure of a semiconductor device according to a third embodiment of the present invention;
Fig. 7 is a typical sectional view showing the structure of a semiconductor device according to a fourth embodiment of the present invention;
Fig. 8 is a typical sectional view showing the structure of a conventional STT; and
Figs. 9A and 9B are energy band diagrams showing potential distributions in the STT shown in Fig. 8.

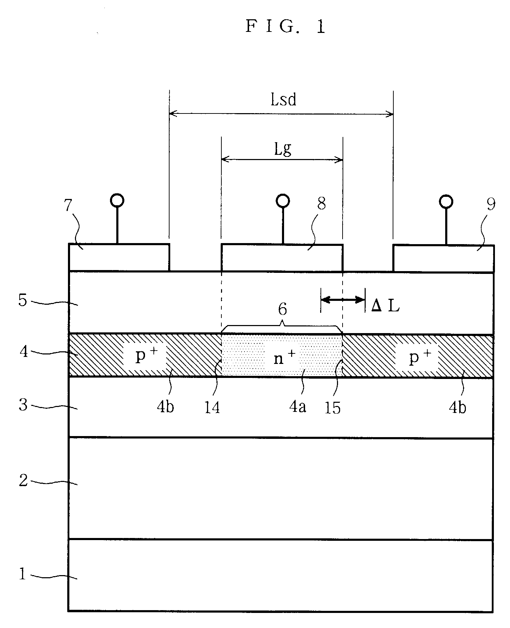

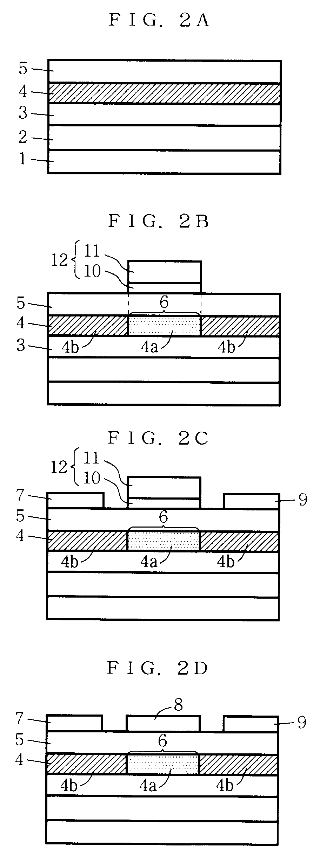

The structure of a semiconductor device according to a first embodiment of the present invention is described with reference to Fig. 1, and a method of fabricating the semiconductor device shown in Fig. 1 is described with reference to Fig. 2.

Fig. 1 is a typical sectional view showing the structure of the semiconductor device according to the first embodiment of the present invention. Referring to Fig. 1, a buffer layer (intermediate layer) 2 formed of undoped GaAs having a thickness of 8000 Å, a barrier layer 3 formed of undoped Al_{0.3}Ga_{0.7}As having a thickness of 300 Å, a channel layer 4 formed of In_{0.15}Ga_{0.85}As having a thickness of 100 Å, and a barrier layer 5 formed of undoped Al_{0.3}Ga_{0.7}As having a thickness of 300 Å are successively formed on a substrate 1 formed of semi-insulating GaAs.

The channel layer 4 is formed of Be-doped p⁺-type In_{0.15}Ga_{0.15}As having a hole concentration of 1 x 10¹⁹ cm⁻³, and a gate electrode opposed part 6 in this channel layer 4 is formed of Si-doped n⁺-type In_{0.15}Ga_{0.85}As having an electron concentration of 5 x 10¹⁸ cm⁻³. Namely, the gate electrode opposed part 6 in the channel layer 4 defines an n⁺-type InGaAs part 4a, and regions located on both sides of the n⁺-type InGaAs part 4a define p⁺-type InGaAs parts 4b.

A Schottky gate electrode 8 formed of a Ti/Al multilayer film is formed on the barrier layer 5, to be opposed to the n⁺-type InGaAs part 4a in the channel layer 4. Further, Ohmic source and drain electrodes 7 and 9 formed of AuGe/Ni/Au multilayer films are formed on both sides of the gate electrode 8 on the barrier layer 5, to be opposed to the p⁺-type InGaAs parts 4b respectively.

In the structure shown in Fig. 1, the forbidden bandwidths of the barrier layers 3 and 5 holding the channel layer 4 therebetween are larger than that of the channel layer 4, whereby the potential energy of the channel layer 4 is lower than those of the barrier layers 3 and 5. Thus, electrons injected from the source electrode 7 are confined in the channel layer 4, to transit therein.

The method of fabricating the semiconductor device shown in Fig. 1 is now described with reference to Figs. 2A to 2D.

In a first step shown in Fig. 2A, the buffer layer (intermediate layer) 2, the barrier layer 3, the channel layer 4 and the barrier layer 5 are formed in this order on the substrate 1 by a crystal growth method such as LPE (liquid phase epitaxy), VPE (vapor phase epitaxy), MBE or MOCVD, for example.

In a second step shown in Fig. 2B, a multilayer film (hereinafter referred to as an SiOₓ/SiN multilayer film) 12 of an SiOₓ film 10 and an SiN film 11 for serving as a supply source of an Si donor is formed on a surface of the barrier layer 5 by plasma CVD or the like, where x < 2.

Thereafter heat treatment is performed at 860°C for six seconds, for diffusing Si atoms in a region shown by dotted lines in Fig. 2B by about 1 x 10²⁰ cm⁻³. In this case, Si is not activated in Al_{0.3}Ga_{0.7}As forming the barrier layer 5, whereby the barrier layer 5 remains undoped. In p⁺-type InGaAs forming the gate electrode opposed part 6 of the channel layer 4, on the other hand, Si compensates for an acceptor in the semiconductor and is activated as a donor. In the case of this embodiment, doping is so performed that an Si-diffused part in the channel layer 4 defines the n⁺-type InGaAs part 4a having an electron concentration of about 5 x 10¹⁸ cm⁻³.

In a third step shown in Fig. 2C, the ohmic source and drain electrodes 7 and 9 are formed on both sides of the SiOₓ/SiN multilayer film 12 on the barrier layer 5. At the same time, alignment marks indicating the position of the SiOₓ/SiN multilayer film 12 are formed on portions out of the element region.

Finally in a fourth step shown in Fig. 2D, the SiOₓ/SiN multilayer film 12 is removed, and the Schottky gate electrode 8 is formed on the same position as the SiOₓ/SiN multilayer film 12 with reference to the alignment marks.

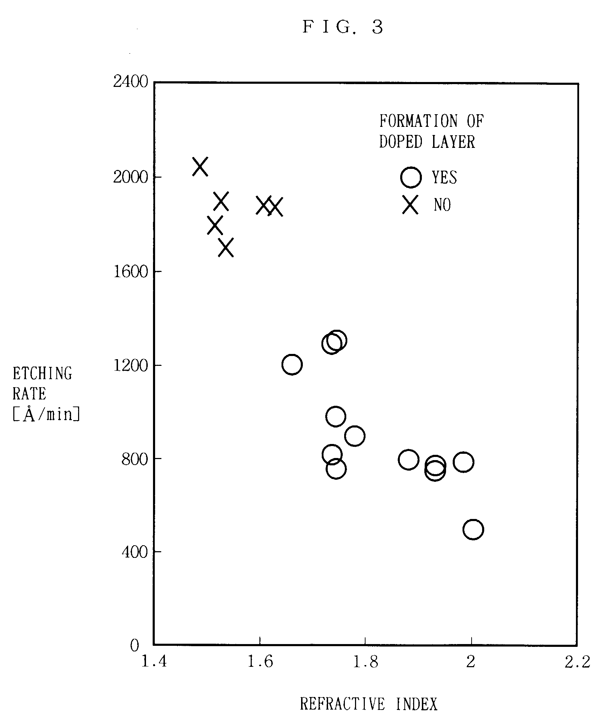

With reference to Fig. 3, the reason why the O composition ratio x of the SiOₓ/SiN multilayer film 12 is less that 2 is described. Fig. 3 is an SiOₓ film quality diagram showing presence/absence of a doped layer in the aforementioned Si diffusion/doping step employing the SiOₓ/SiN multilayer film 12. Referring to Fig. 3, the axis of ordinates shows the etching rate for the SiOₓ film with buffer hydrofluoric acid, and the axis of abscissas shows the refractive index of the SiOₓ film.

In general, the etching rate for the SiOₓ film is reduced when the Si content in the SiOₓ film is increased. Further, the refractive index of the SiOₓ film is increased when the Si content is increased.

It is understood from Fig. 3 that no doped layer is formed when an SiOₓ film at a high etching rate, i.e., with a small Si content is employed, while a doped layer is formed when an SiOₓ film at a low etching rate, i.e., with a large Si content is employed. Further, it is also understood that no doped layer is formed when an SiOₓ film at a low refractive index, i.e., with a low Si content is employed, while a doped layer is formed when an SiOₓ film at a high refractive index, i.e., with a large Si content is employed.

The refractive index of a thermally oxidized SiO₂ film is about 1.46, and an SiOₓ film having a larger refractive index than the thermally oxidized SiO₂ film has an O composition ratio of less than 2. Thus, Fig. 3 shows that no doped layer can be formed when an SiO₂ film having a refractive index of about 1.5 is employed while a doped layer can be formed when an SiOₓ film having a large refractive index and an O composition ratio x of less than 2 is employed.

Namely, the O composition ratio x in the SiOₓ film is set to be less than 2 in the aforementioned doping step, since the SiOₓ film (x < 2) has Si-excessive film quality as compared with the stable SiO₂ film and hence excess Si is readily decomposed by the heat treatment and diffused into the semiconductor.

When the aforementioned Si diffusion/doping with the SiOₓ/SiN multilayer film 12 is employed, the Si concentration is reduced by at least one figure within a five-molecule layer on the interface between the Si-diffused part and the non-diffused part, whereby the p⁺-type InGaAs parts 4b and the n⁺-type InGaAs part 4a in the channel layer 4 form extremely abrupt P-N junction interfaces.

In the semiconductor device according to this embodiment, the p⁺-type InGaAs part 4b in the channel layer 4 opposed to the source electrode 7 and the n⁺-type InGaAs part 4a of the gate electrode opposed part 6 form an abrupt P-N junction interface 14, and the p⁺-type InGaAs part 4b in the channel layer 4 opposed to the drain electrode 9 and the n⁺-type InGaAs part 4a of the gate electrode opposed part 6 form another abrupt P-N junction interface15.

When a positive voltage is applied between the source electrode 7 and the drain electrode 9, for example, the P-N junction interface 15 has a band structure similar to that shown in Fig. 9A. At this time, a forward bias is applied to the P-N junction interface 14. Electrons injected from the source electrode 7 pass through the P-N junction interface 14, further pass through the forbidden band of the P-N junction interface 15 from the conduction band of the n⁺-type InGaAs part 4a of the gate electrode opposed part 6 by the tunnel effect, and pass through the valence band of the p⁺-type InGaAs part 4b opposed to the drain electrode 9 to reach the drain electrode 9. Thus, a current flows between the source electrode 7 and the drain electrode 9.

When a voltage is then applied to the gate electrode 8 in this state, the carrier concentration of the n⁺-type InGaAs part 4a of the gate electrode opposed part 6 is changed, thereby changing the tunneling probability of the electrons at the P-N junction interface 15. Consequently, the drain current is changed.

According to this embodiment, the barrier layer 3 corresponds to a first semiconductor layer, the channel layer 4 corresponds to a second semiconductor layer, and the barrier layer 5 corresponds to a third semiconductor layer.

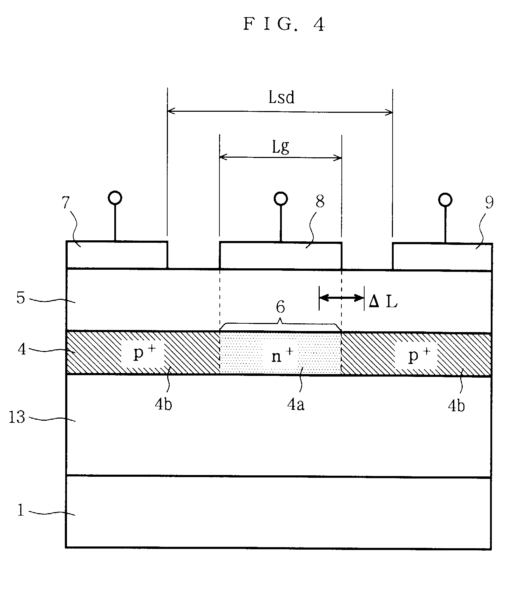

With reference to Fig. 4, a semiconductor device according to a second embodiment of the present invention is now described. Fig. 4 is a typical sectional view showing the structure of the semiconductor device according to the second embodiment of the present invention.

Referring to Fig. 4, a buffer layer 13 formed of undoped GaAs having a thickness of 8000 Å, a channel layer 4 formed of In_{0.15}Ga_{0.85}As having a thickness of 100 Å, and a barrier layer 5 formed of undoped Al_{0.3}Ga_{0.7}As having a thickness of 300 Å are successively formed on a substrate 1 formed of semi-insulating GaAs. The structure of the remaining part of the semiconductor device according to this embodiment is similar to that of the semiconductor device according to the first embodiment.

In the semiconductor device according to this embodiment, the buffer layer 13 serves both as the buffer layer 2 and the barrier layer 3 in the first embodiment. In general, a semiconductor such as AlGaAs having a large forbidden bandwidth hardly attains a flat growth plane in crystal growth, and requires a higher growth temperature as compared with a semiconductor having a narrow forbidden bandwidth. In this embodiment, the forbidden bandwidth of the buffer layer 13 is substantially identical to that of the channel layer 4, whereby crystal growth conditions for the buffer layer 13 and the channel layer 4 are substantially identical to each other and the channel layer 4 can be readily formed on the buffer layer 13. This buffer layer 13 corresponds to a first semiconductor layer.

As to the dimensions of the electrodes in each of the first and second embodiments, the length Lg of the gate electrode 8 is 0.1 µm, and the distance Lsd between the source electrode 7 and the drain electrode 9 is 0.2 µm, for example. In this case, the position of a drain end of the gate electrode 8 may be displaced from a portion immediately above the P-N junction interface 15 formed by the p⁺-type InGaAs part 4b in the channel layer 4 opposed to the drain electrode 9 and the n₊-type InGaAs part 4a in the channel layer 4 by about ΔL = ±0.05 µm.

The barrier layers 3 and 5 in the first embodiment and the barrier layer 5 in the second embodiment are prepared from AlGaAs having an Al mole ratio (Al composition ratio) of at least 0.25. The reason for this is now described.

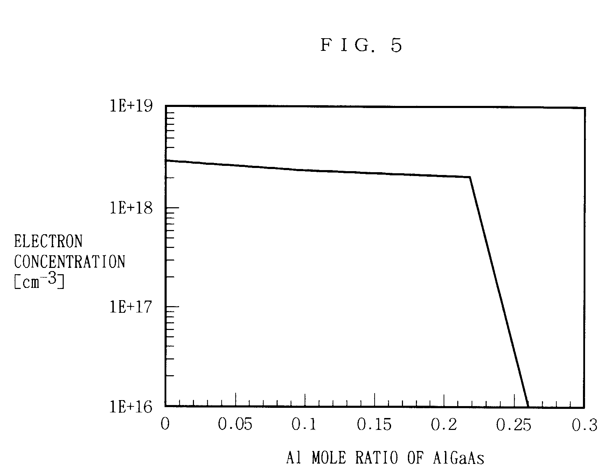

Fig. 5 is a characteristic diagram showing an experimental result of the relation between the Al mole ratio of AlGaAs in case of employing Si diffusion/doping by an SiOₓ/SiN multilayer film and the electron concentration in the doped AlGaAs. The electron concentration indicates the concentration of electrons serving as carriers.

As understood from Fig. 5, Si is hardly activated as a dopant supplying carriers when the Al mole ratio y of Al_{y}Ga_{1-y}As is greater than 0.25 in case of employing the aforementioned Si diffusion/doping. In the first and second embodiments of the present invention, therefore, the Al mole ratio y of Al_{y}Ga_{1-y}As forming the barrier layers 3 and 5 may be at any value within the range of 0.25 to 1.

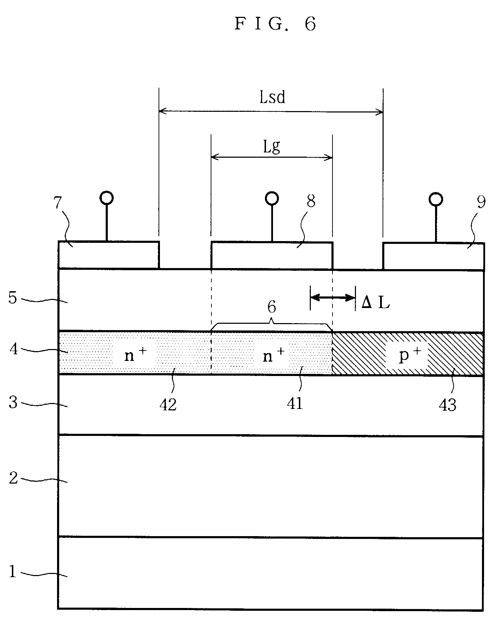

Fig. 6 is a typical sectional view showing the structure of a semiconductor device according to a third embodiment of the present invention. Referring to Fig. 6, a gate electrode opposed part 6 of a channel layer 4 defines an n⁺-type InGaAs part 41, a region adjacent to the n⁺-type InGaAs part 41 on a source electrode side defines an n⁺-type InGaAs part 42, and a region adjacent to the n⁺-type InGaAs part 41 on a drain electrode side defines a p⁺-type InGaAs part 43. The structure of the remaining part of the semiconductor device according to this embodiment is similar to that of the semiconductor device according to the first embodiment.

The semiconductor device according to the third embodiment can be fabricated by forming an SiO₂/SiN multilayer film on a gate electrode forming region of a barrier layer 5 and a region adjacent to the gate electrode forming region on a source electrode forming region side and performing the aforementioned Si diffusion/doping.

In the semiconductor device according to this embodiment, the p⁺-type InGaAs part 43 and the n⁺-type InGaAs part 41 form an abrupt P-N junction interface. The n⁺-type InGaAs part 42 may be replaced with an n-type InGaAs part.

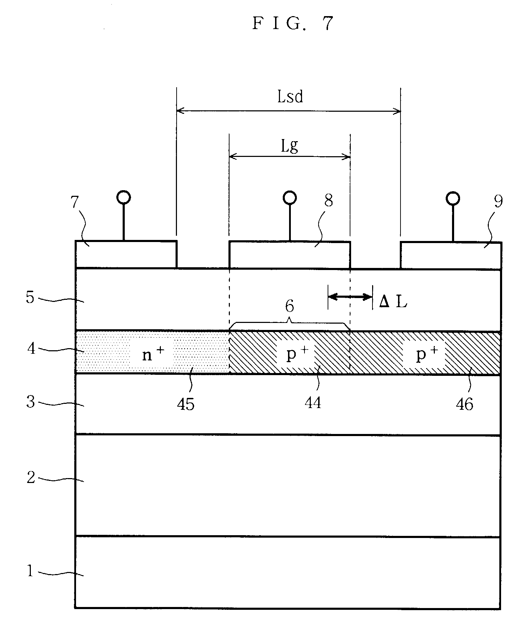

Fig. 7 is a typical sectional view showing the structure of a semiconductor device according to a fourth embodiment of the present invention. Referring to Fig. 7, a gate electrode opposed part 6 of a channel layer 4 defines a p⁺-type InGaAs part 44, a region adjacent to the p⁺-type InGaAs part 44 on a source electrode side defines an n⁺-type InGaAs part 45, and a region adjacent to the p⁺-type InGaAs part 44 on a drain electrode side defines a p⁺-type InGaAs part 46. The remaining part of the semiconductor device according to this embodiment is similar to that of the semiconductor device according to the first embodiment.

The semiconductor device according to the fourth embodiment can be fabricated by forming an SiO₂/SiN multilayer film on region adjacent to a gate electrode forming region on a source electrode side of a barrier layer 5 and performing the aforementioned Si diffusion/doping.

In the semiconductor device according to this embodiment, the p⁺-type InGaAs part 44 and the n⁺-type InGaAs part 45 form an abrupt P-N junction interface. The P⁺-type InGaAs part 46 may be replaced with a p-type InGaAs part.

Finally, exemplary material structures other than those employed in the aforementioned embodiments are described. First, the In mole ratio z of In_{z}Ga_{1-z}As forming the channel layer 4 may be at any value within the range of 0 to 1. In order to simplify formation of the ohmic electrodes 7 and 9 on the barrier layer 5, a semiconductor such as GaAs or InGaAs, for example, having a narrower forbidden bandwidth than the barrier layer 5 may be formed on the barrier layer 5, or a P⁺-type semiconductor reaching the channel layer 4 may be provided under the source and drain electrodes 7 and 9.

As to another combination of materials, the substrate 1, the buffer layer 2, the barrier layer 3, the channel layer 4 and the barrier layer 5 may be prepared from InP, InGaAs, InAlAs, InGaAs or InAs, and InAlAs respectively.

Further, all of the aforementioned semiconductors may be replaced with combinations of semiconductors having various compositions of In, Ga, Al, Sb, As and P. Further, the dopant for the p-type semiconductor may be prepared from any of Zn, Mg, Ge and C or a combination thereof, in addition to the above. On the other hand, the dopant for the n-type semiconductor may be prepared from any of Se, S and Ti or a combination thereof, in addition to the above.

In the method of fabricating the semiconductor device shown in Figs. 2A to 2D, the p-type semiconductor may be formed by impurity diffusion or ion implantation in place of the aforementioned crystal growth, and the ohmic electrodes etc. may be formed by the so-called self alignment, in place of the aforementioned method employing the alignment marks.

Although the present invention has been described and illustrated in detail, it is clearly understood that the same is by way of illustration and example only and is not to be taken by way of limitation.

## Claims

1. A semiconductor device comprising:
a first semiconductor layer, a second semiconductor layer, a third semiconductor layer and a gate electrode in this order, wherein
said second semiconductor layer has a narrower forbidden bandwidth than said third semiconductor layer,
a first region being opposed to said gate electrode in said second semiconductor layer has a first conductivity type, and
a second region being adjacent to at least one side of said first region in said second semiconductor layer has a second conductivity type being reverse to said first conductivity type.

2. The semiconductor device in accordance with claim 1, wherein
said second region includes regions located on both sides of said first region in said second semiconductor layer.

3. The semiconductor device in accordance with claim 1, wherein
said first semiconductor layer has a larger forbidden bandwidth than said second semiconductor layer.

4. The semiconductor device in accordance with claim 1, wherein
said first semiconductor layer has a forbidden bandwidth being substantially equal to that of said second semiconductor layer.

5. The semiconductor device in accordance with claim 1, wherein
said first region is doped with first conductivity type impurities in high concentration, said second region is doped with second conductivity type impurities in high concentration, and said first region and said second region form an abrupt P-N junction interface.

6. The semiconductor device in accordance with claim 1, further comprising a semiconductor substrate and a buffer layer being formed on said semiconductor substrate,
said first semiconductor layer being formed on said buffer layer.

7. The semiconductor device in accordance with claim 1, further comprising a semiconductor substrate,
said first semiconductor layer being formed on said semiconductor substrate.

8. The semiconductor device in accordance with claim 1, further comprising first and second ohmic electrodes being formed on both sides of said gate electrode on said third semiconductor layer respectively.

9. The semiconductor device in accordance with claim 1, wherein
said first semiconductor layer is formed of AlGaAs or GaAs, said second semiconductor layer is formed of InGaAs, and said third semiconductor layer is formed of AlGaAs.

10. The semiconductor device in accordance with claim 1, wherein
said first semiconductor layer is formed of InAlAs, said second semiconductor layer is formed of InGaAs or InAs, and said third semiconductor layer is formed of InAlAs.

11. The semiconductor device in accordance with claim 1, wherein
said first region of said second semiconductor layer is formed by diffusion of first conductivity type impurities into a second conductivity type semiconductor.

12. The semiconductor device in accordance with claim 1, wherein
said first region is formed of an n-type semiconductor material, and said second region is formed of a p-type semiconductor material.

13. The semiconductor device in accordance with claim 1, further comprising source and drain electrodes formed on said third semiconductor layer on both sides of said gate electrode, wherein
said second region is a region adjacent to said first region on said drain electrode side in said second semiconductor layer, said first region and a region adjacent to said first region on said source electrode side are formed of an n-type semiconductor, and said second region is formed of a p-type semiconductor.

14. The semiconductor device in accordance with claim 1, further comprising source and drain electrodes formed on said third semiconductor layer on both sides of said gate electrode respectively, wherein
said second region is a region adjacent to said first region on said source electrode side in said second semiconductor layer, said first region and a region adjacent to said first region on said drain electrode side are formed of a p-type semiconductor, and said second region is formed of an n-type semiconductor.

15. The semiconductor device in accordance with claim 1, wherein
said third semiconductor layer is a compound semiconductor formed of AlGaAs having an Al mole ratio of at least 0.25.

16. The semiconductor device in accordance with claim 1, wherein
said first semiconductor layer is a compound semiconductor formed of AlGaAs having an Al mole ratio of at least 0.25.

17. A method of fabricating a semiconductor device, comprising steps of:
forming a first semiconductor layer, a second semiconductor layer, and a third semiconductor layer having a larger forbidden bandwidth than said second semiconductor layer in this order so that interfaces thereof are parallel to each other;
forming a first region being opposed to a gate electrode forming region on said third semiconductor layer in said second semiconductor layer and a second region being adjacent to at least one side of said first region in said second semiconductor layer in conductivity types reverse to each other; and
forming a gate electrode on said gate electrode forming region on said third semiconductor layer.

18. The method of fabricating a semiconductor device in accordance with claim 17, wherein
said second region includes regions located on both sides of said first region in said second semiconductor layer.

19. The method of fabricating a semiconductor device in accordance with claim 17, wherein
said first semiconductor layer has a larger forbidden bandwidth than said second semiconductor layer.

20. The method of fabricating a semiconductor device in accordance with claim 17, wherein
said first semiconductor layer has a forbidden bandwidth being substantially equal to that of said second semiconductor layer.

21. The method of fabricating a semiconductor device in accordance with claim 17, wherein
said step of forming said first and second regions in said conductivity types reverse to each other includes a step of doping said first region with first conductivity type impurities in high concentration and doping said second region with second conductivity type impurities in high concentration, thereby forming an abrupt P-N junction interface of said first and second regions.

22. The method of fabricating a semiconductor device in accordance with claim 17, wherein
said step of forming said first and second regions in said conductivity types reverse to each other includes a step of diffusing first conductivity type impurities into a second conductivity type semiconductor.

23. The method of fabricating a semiconductor device in accordance with claim 17, wherein
said step of forming said first and second regions in said conductivity types reverse to each other includes steps of:
forming a film containing an element for serving as first conductivity type impurities in excess on said gate electrode forming region on said third semiconductor layer, and
diffusing said element for serving as said first conductivity type impurities being contained in said semiconductor film into said second semiconductor layer through said third semiconductor layer by heat treatment.

24. The method of fabricating a semiconductor device in accordance with claim 17, wherein
said step of forming said first and second regions in said conductivity types reverse to each other includes steps of:
forming a multilayer film of an SiOₓ film (x < 2) and an SiN film on said gate electrode forming region on said third semiconductor layer, and
diffusing Si being contained in said multilayer film into said second semiconductor layer through said third semiconductor layer by heat treatment.

25. The method of fabricating a semiconductor device in accordance with claim 24, wherein
Si being diffused in said third semiconductor layer is inactive.

26. The method of fabricating a semiconductor device in accordance with claim 24, wherein
said third semiconductor layer is a compound semiconductor formed of AlGaAs having an Al mole ratio of at least 0.25.

27. The method of fabricating a semiconductor device in accordance with claim 26, wherein
said first semiconductor layer is a compound semiconductor formed of AlGaAs having an Al mole ratio of at least 0.25.

28. The method of fabricating a semiconductor device in accordance with claim 17, further comprising a step of forming first and second ohmic electrodes on both sides of said gate electrode forming region on said third semiconductor layer respectively.

29. The method of fabricating a semiconductor device in accordance with claim 17, wherein
said step of forming said first and second regions in said conductivity types reverse to each other includes steps of:
forming a film containing an element for serving as first conductivity type impurities in excess on said gate electrode forming region of said third semiconductor layer and on a region adjacent to said gate electrode forming region on a source electrode forming region side, and
diffusing said element for serving as said first conductivity type impurities contained in said film into said second semiconductor layer through said third semiconductor layer by heat treatment.

30. The method of fabricating a semiconductor device in accordance with claim 17, wherein
said step of forming said first and second regions in said conductivity types reverse to each other includes steps of:
forming a film containing an element for serving as second conductivity type impurities in excess on a region adjacent to said gate electrode forming region on a source electrode forming region side of said third semiconductor layer, and
diffusing said element for serving as said second conductivity type impurities contained in said film into said second semiconductor layer through said third semiconductor layer by heat treatment.

31. The method of fabricating a semiconductor device in accordance with claim 17, wherein
said step of forming said first and second regions in said conductivity types reverse to each other includes steps of:
forming a multilayer film of an SiOₓ film (x < 2) and an SiN film on said gate electrode forming region of said third semiconductor layer and on a region adjacent to said gate electrode forming region on a source electrode forming region side, and
diffusing Si contained in said multilayer film into said second semiconductor layer through said third semiconductor layer by heat treatment.

32. The method of fabricating a semiconductor device in accordance with claim 17, wherein
said step of forming said first and second regions in said conductivity types reverse to each other includes steps of:
forming a multilayer film of an SiOₓ film (x < 2) and an SiN film on a region adjacent to said gate electrode forming region on a source electrode forming region side of said third semiconductor layer, and
diffusing Si contained in said multilayer film into said second semiconductor layer through said third semiconductor layer by heat treatment.

33. A method of fabricating a semiconductor device, comprising steps of:
forming a first semiconductor layer, a second semiconductor layer and a third semiconductor layer in this order so that interfaces thereof are parallel to each other;
forming a multilayer film of an SiOₓ film (x < 2) and an SiN film on a prescribed region with reference to a gate electrode forming region on said third semiconductor layer;
diffusing Si being contained in said multilayer film into said second semiconductor layer through said third semiconductor layer by heat treatment; and
forming a gate electrode on said gate electrode forming region on said third semiconductor layer.

34. The method of fabricating a semiconductor device in accordance with claim 33, wherein
Si being diffused in said third semiconductor layer is inactive.

35. The method of fabricating a semiconductor device in accordance with claim 33, wherein
said third semiconductor layer is a compound semiconductor formed of AlGaAs having an Al mole ratio of at least 0.25.

36. The method of fabricating a semiconductor device in accordance with claim 35, wherein
said first semiconductor layer is a compound semiconductor formed of AlGaAs having an Al mole ratio of at least 0.25.

37. The method of fabricating a semiconductor device in accordance with claim 33, wherein
said prescribed region with reference to said gate electrode forming region is said gate electrode forming region.

38. The method of fabricating a semiconductor device in accordance with claim 33, wherein
said prescribed region with reference to said gate electrode forming region is said gate electrode forming region and a region adjacent to said gate electrode forming region on a source electrode forming region side.

39. The method of fabricating a semiconductor device in accordance with claim 33, wherein
said prescribed region with reference to said gate electrode forming region is a region adjacent to said gate electrode forming region on a source electrode forming region side.
